# EUROPEAN PATENT APPLICATION

(11) **EP 2 511 744 A1**
(43) Date of publication of application: **17.10.2012**
(21) Application number: 11774295.7
(22) Date of filing: 24.02.2011
(51) Int. Cl.: G02B 6/43, H01P 5/19, H05K 1/00, H05K 7/10, H04B 10/00

(54) **OPTICAL BACKPLANE INTERCONNECTION SYSTEM AND COMMUNICATION DEVICE**

(30) Priority: 26.04.2010 CN 201010158509
(71) Applicant: Huawei Technologies Co., Ltd., Shenzhen, Guangdong 518129 (CN)
(72) Inventor: JIA, Gongxian, Shenzhen (CN); LIU, Weixia, Shenzhen (CN); WANG, Zewen, Shenzhen (CN)
(74) Representative: Kreuz, Georg Maria
(86) International application number: PCT/CN2011/071272
(87) International publication number: WO 2011/134304

(57) **Abstract**

Embodiments of the present invention provide an optical backplane interconnection system and a communication device. The optical backplane interconnection system includes a backplane, a front board, a rear board and a connector. The front board and the rear board locate on two sides of the backplane and are orthogonal to each other. The front board and the rear board are both disposed with an optical waveguide path which is interconnected through a connector connected to the backplane to form an optical path, so that optical signals can be transmitted through the optical path. In the embodiments of the present invention, the front board and the rear board of a circuit board locate on two sides of the backplane and are disposed to be orthogonal to each other, and the optical waveguide paths in the front board and the rear board are interconnected directly through the connector to form the optical path, thereby implementing the transmission of optical signals, shortening an optical link, and reducing the loss of the optical signals. By using the optical waveguide path, the embodiments of the present invention improve the processing performance of the system, and reduce the complexity of physical implementation of a high-density fiber backplane.

## Description

This application claims priority to Chinese Patent Application No. 201010158509.0, filed with the Chinese Patent Office on April 26, 2010 and entitled "OPTICAL BACKPLANE INTERCONNECTION SYSTEM AND COMMUNICATION DEVICE", which is incorporated herein by reference in its entirety.

### FIELD OF THE INVENTION

The present invention relates to the field of communication device technologies, and in particular, to an optical backplane interconnection system and a communication device.

### BACKGROUND OF THE INVENTION

In a communication system, access capacity of a device becomes larger and larger along with the increasing improvement of signal rate, and correspondingly, the system bandwidth is increased. Adding the number of buses is one of the manners of increasing the system bandwidth. However, with the limitations such as chip technologies, processes, and heat dissipation, currently, the implementation of a large-capacity electrical interconnection system becomes more and more difficult, and optical interconnection has advantages such as low loss, low cross-talk, high density, and channel characteristic unrelated with rate, so an optical backplane interconnection system becomes a preferred solution.

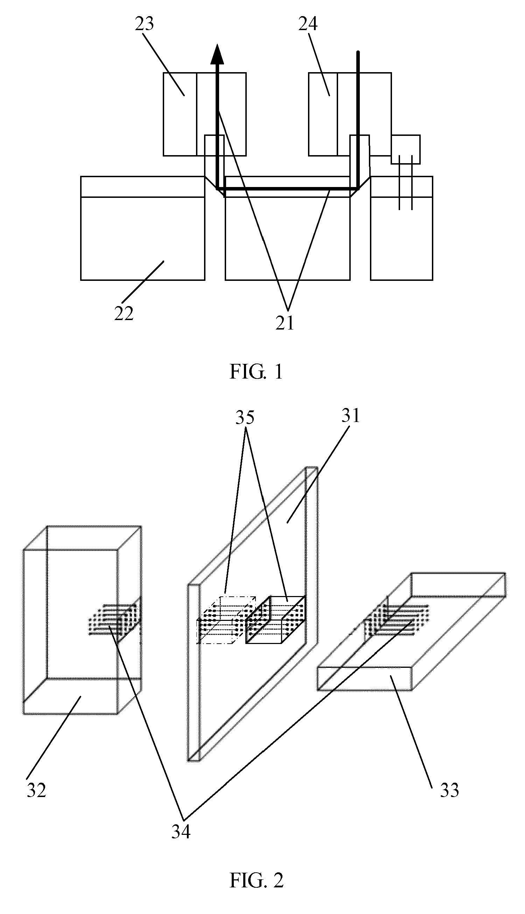

In the prior art, an adopted optical backplane interconnection system is specifically an optical waveguide backplane interconnection system, as shown in FIG. 1, waveguide paths 21 are processed layer by layer as in the conventional printed circuit board technique, and an optical waveguide backplane 22 and circuit boards 23, 24 are obtained through pressing. Optical signals are received by the circuit board 23, and output from the circuit board 24 through the waveguide path in the optical waveguide backplane 22, thereby implementing the transmission of the optical signals. However, during the research of implementing the present invention, the inventor finds that, the optical waveguide itself has large signal loss, and an optical link in the solution is long, so that the optical signal loss is larger, and the signal transmission quality is reduced.

### SUMMARY OF THE INVENTION

Embodiments of the present invention provide an optical backplane interconnection system and a communication device, which are capable of shortening the length of an optical link, and reducing the loss of optical signals.

In order to solve the foregoing technical problems, technical solutions of the embodiments of the present invention are as follows:

An embodiment of the present invention provides an optical backplane interconnection system, which includes a backplane, a circuit board and a connector. The circuit board includes a front board and a rear board. The front board and the rear board locat on two sides of the backplane and are orthogonal to each other. The front board and the rear board both have an optical waveguide path which is interconnected through a connector connected to the backplane to form an optical path, so that optical signals are transmitted through the optical path.

An embodiment of the present invention further provides a communication device, which includes the optical backplane interconnection system, and a switch board connected to the optical backplane interconnection system.

In the embodiments of the present invention, the front board and the rear board of a circuit board locat on two sides of the backplane and are disposed to be orthogonal to each other, and the optical waveguide paths in the front board and the rear board are interconnected directly through the connector to form the optical path, thereby implementing the transmission of optical signals without establishing an optical waveguide path on the backplane, shortening an optical link, reducing the loss of the optical signals, and improving the transmission quality of the optical signals.

### BRIEF DESCRIPTION OF THE DRAWINGS

To describe the technical solutions according to the embodiments of the present invention or in the prior art more clearly, the accompanying drawings for describing the embodiments or the prior art are introduced briefly in the following. Apparently, the accompanying drawings in the following description are only some embodiments of the present invention, and persons of ordinary skill in the art can derive other drawings from the accompanying drawings without creative efforts.

FIG. 1 is a schematic structural diagram of an optical backplane interconnection system in the prior art;

FIG. 2 is a schematic structural diagram of an optical backplane interconnection system in an embodiment of the present invention;

FIG. 3 is a schematic diagram of transmission of optical signals in the optical backplane interconnection system shown in FIG. 3 in an embodiment of the present invention;

FIG. 4 is a schematic structural diagram of another optical backplane interconnection system in an embodiment of the present invention;

FIG. 5 is a schematic structural diagram of a first positioning apparatus in an embodiment of the present invention;

FIG. 6 is a schematic structural diagram of a third positioning apparatus in an embodiment of the present invention;

FIG. 7 is a schematic structural diagram of a fourth positioning apparatus in an embodiment of the present invention;

FIG. 8 is a schematic structural diagram of another optical backplane interconnection system in an embodiment of the present invention;

FIG. 9 is a schematic structural diagram of a communication device in an embodiment of the present invention; and

FIG. 10 is a schematic structural diagram of an optical backplane interconnection system in an embodiment of the present invention.

### DETAILED DESCRIPTION OF THE EMBODIMENTS

Persons in the art may further understand features and technical content of the embodiments of the present invention with reference to detailed descriptions and accompanying drawings of the embodiments of the present invention, and the accompanying drawings are provided only for reference and illustration, instead of limiting the embodiments of the present invention.

In the prior art, multi-layer polymer waveguide is obtained by performing processing of a conventional PCB (Printed Circuit Board, printed circuit board) processing technology, so that an optical backplane interconnection system has better processing performance, thereby preventing the problem of the complexity of physical implementation of a high-density fiber backplane. However, the optical waveguide itself has a large signal loss, and the optical link in the prior art is long, so that the optical signal loss is large, and the signal transmission quality is reduced. Based on this, the embodiments of the present invention not only adopt an optical waveguide path to reduce the complexity of physical implementation of the optical backplane interconnection system, but also locate a front board and a rear board of a circuit board respectively on the two sides of a backplane and arranges them to be orthogonal to each other, omit the optical waveguide path in the backplane, interconnect the optical waveguide paths in the front board and the rear board directly through a connector to implement the transmission of optical signals, thereby shortening the optical link, and reducing the loss of the optical signals.

Technical solutions of the embodiments of the present invention are described through the accompanying drawings and embodiments.

Referring to FIG. 2, a schematic structural diagram of an optical backplane interconnection system in an embodiment of the present invention is shown.

The optical backplane interconnection system includes a backplane 31, a circuit board and a connector 35.

The circuit board further includes a front board 32 and a rear board 33. The front board 32 and the rear board 33 locate on two sides of the backplane 31 and are orthogonal to each other, so as to implement interconnection of signals at different slots.

The front board 32 and the rear board 33 both have an optical waveguide path 34, where, the optical waveguide paths 34 may be of an embedded type, that is, embedded in printed circuit boards of the front board and the rear board, and may also disposed on the external of the front board and the rear board, and the optical waveguide paths 34 may be rigid optical waveguide paths or flexible optical waveguide paths.

The connector 35 is connected to the backplane 31, and is configured to connect the circuit board and the backplane 31, implement that the circuit board is inserted in and pulled out the backplane 31, and further connect the optical waveguide paths of the front board and the rear board. Specifically, a mounting hole may be disposed on the backplane 31, and the connector 35 is inserted in the mounting hole to implement the connection with the front board and the rear board. Optical waveguide paths may be disposed in the connector 35, so that the optical waveguide paths 34 of the front board 32 and the rear board 33 are interconnected through the connector 35 on the backplane 31 to form an optical path, so that optical signals are transmitted through the optical path.

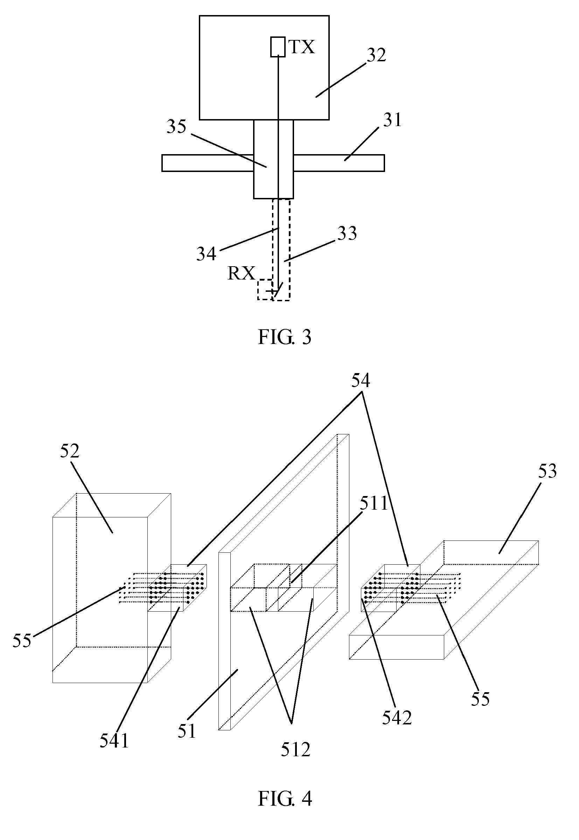

In this embodiment, if the optical waveguide paths 34 of the front board and the rear board are of an embedded type, that is, embedded in the printed circuit boards of the front board and the rear board, the transmission of the optical signals in the optical backplane interconnection system is shown in FIG. 4. An optical signal of a transmitting chip (TX) enters the optical waveguide path 34 of the front board 32 through a reflector and is transmitted through the connector 35 to the rear board 33 at the rear side of the backplane 31, and the optical signal enters a receiving chip (RX) through a reflector, thereby implementing the transmission of the signal. In an embodiment, if the optical waveguide paths of the front board and the rear board adopt flexible optical waveguide paths, for example, flexible waveguide plates, a reflector configured to implement 90 degrees turning of an optical path may be omitted, thereby further reducing the additional loss.

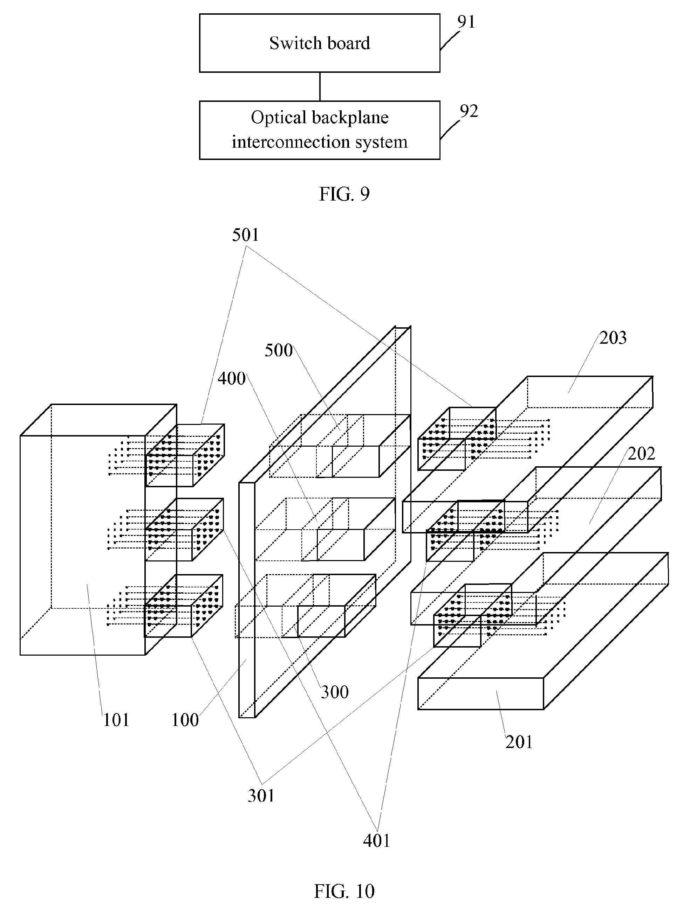

It should be noted that, in an embodiment, FIG. 10 is a schematic structural diagram of an optical backplane interconnection system in an embodiment of the present invention. As shown in FIG. 10, when multiple front boards (front boards 201-203 shown in the drawing) and one rear board 101 exist, the front boards 201-203 and the rear board 101 locate on two sides of the backplane 100 and are disposed to be orthogonal to each other, in this case, the one rear board 101 may be interconnected with the multiple front boards 201-203 respectively through multiple connectors (a connector 301, a connector 401 and a connector 501 in the drawing), and form an optical path with each front board after the interconnection, therefore, it is unnecessary to dispose an optical waveguide on the backplane, and direct communication with each front board implements the transmission of optical signals. As shown in FIG. 10, the connector 301, the connector 401 and the connector 501 may be mounted on the backplane 100 respectively through a base 300, a base 400 and a base 501 disposed on the backplane 100.

In an embodiment, when one front board or multiple rear boards exist, similar effect is obtained, which is not repeated herein.

In an embodiment, when multiple front boards and multiple rear boards exist, the front boards and the rear boards locate on two sides of the backplane and are disposed to be orthogonal to each other, at this time, each rear board may be interconnected with each front board through a connector disposed at a corresponding position on the backplane, so as to form an optical path with each front board after the interconnection; therefore, it is unnecessary to dispose an optical waveguide on the backplane, and each rear board and each front board are enabled to communicate with each other directly to implement the transmission of optical signals.

In the embodiments of the present invention, the front board and the rear board of a circuit board locate on two sides of the backplane and are disposed to be orthogonal to each other, and the optical waveguide paths in the front board and the rear board are interconnected directly through the connector to form the optical path, thereby implementing the transmission of optical signals without establishing an optical waveguide path on the backplane, shortening an optical link, and reducing the loss of the optical signals. By using the optical waveguide path, the embodiments of the present invention improve the processing performance of the system, and reduce the complexity of physical implementation of a high-density fiber backplane. Moreover, the backplane of the system does not have an optical waveguide path, which also reduces the difficulty of physical implementation of the system.

In another embodiment of the present invention, in order to implement accurate interconnection between the optical waveguide paths of the front board 32 and the rear board 33, positioning apparatuses, such as a positioning pin and a positioning hole, may be further disposed on the front board and the rear board.

Referring to FIG. 4, a schematic structural diagram of another optical backplane interconnection system in an embodiment of the present invention is shown.

The optical backplane interconnection system may include a backplane 51, a front board 52, a rear board 53 and a connector 54.

In this embodiment, the backplane 51 has a mounting hole 511, and a base 512 may be further disposed at the mounting hole 511.

The front board 52 and the rear board 53 locate on two sides of the backplane 51 and are orthogonal to each other, the front board 52 and the rear board 53 both have an optical waveguide path 55, and the optical waveguide paths 55 in the front board and the rear board extend to edges of the boards. In this embodiment, the optical waveguide paths 55 are of an embedded type, that is, they are rigid optical waveguide paths embedded in printed circuit boards of the front board and the rear board.

The connector 54 may include a first terminal 541 connected to the front board 52, and a second terminal 542 connected to the rear board 53, where, the first terminal 541 and the second terminal 542 both have an optical waveguide path, the first terminal and the second terminal may be inserted in the base 512 of the backplane 51, thereby implementing the interconnection between the optical waveguide paths of the two terminals, so that the optical waveguide paths on the front board 52, the first terminal 541 of the connector, the second terminal 542 of the connector and the rear board 53 are interconnected sequentially to form an optical path, so that optical signals are transmitted through the optical path. The front board 52, the first terminal 541, the backplane 51, the base 512, the second terminal 542 and the rear board 53 may all be independent components, and when they are connected to form an optical backplane interconnection system, the base 512 may be inserted in the mounting hole 511 of the backplane 51, the front board 52 and the first terminal 541 are interconnected to be fixed, the rear board 53 and the second terminal 542 are interconnected to be fixed, and are inserted in the base 512 respectively on the two sides of the backplane 51.

In this embodiment, the transmission procedure of an optical signal in the optical backplane interconnection system is that, an optical signal of the transmitting chip (TX) enters the optical waveguide path 55 of the front board 52 through a reflector, and is transmitted to the rear board 53 at the rear side of the backplane 51 through the first terminal 541 and the second terminal 542 of the connector 54, and the optical signal enters the receiving chip (RX) through the reflector, thereby implementing the transmission of the signal.

It should be noted that, in an embodiment, as shown in FIG. 10, when multiple front boards (front boards 201-203 shown in the drawing) and one rear board 101 exist, the front boards 201-203 and the rear board 101 locate on two sides of the backplane 100 and are disposed to be orthogonal to each other, at this time, the one rear board 101 may be interconnected with the multiple front boards 201-203 respectively through multiple connectors (a connector 301, a connector 401 and a connector 501 in the drawing), and form an optical path with each front board after the interconnection, therefore, it is unnecessary to dispose an optical waveguide on the backplane, and direct communication with each front board implements the transmission of optical signals. As shown in FIG. 10, the connector 301, the connector 401 and the connector 501 may be mounted on the backplane 100 respectively through a base 300, a base 400 and a base 501 disposed on the backplane 100.

In an embodiment, when one front board or multiple rear boards exist, similar effect is obtained, which is not repeated herein.

In an embodiment, when multiple front boards and multiple rear boards exist, the front boards and the rear boards locate on two sides of the backplane and are disposed to be orthogonal to each other, at this time, each rear board may be interconnected with each front board through a connector disposed at a corresponding position on the backplane, so as to form an optical path with each front board after the interconnection; therefore, it is unnecessary to dispose an optical waveguide on the backplane, and each rear board and each front board are enabled to communicate with each other directly to implement the transmission of optical signals.

In the embodiments of the present invention, the front board and the rear board of a circuit board locate on two sides of the backplane and are disposed to be orthogonal to each other, and the optical waveguide paths in the front board and the rear board are interconnected through the first terminal and the second terminal of the connector to form the optical path, thereby shortening an optical link, and reducing the loss of the optical signals. By using the optical waveguide path, the embodiments of the present invention improve the processing performance of the system, and reduce the complexity of physical implementation of a high-density fiber backplane. Moreover, the backplane of the system does not have an optical waveguide path, which also reduces the difficulty of physical implementation of the system.

The optical waveguide is small, generally between 30 microns and 50 microns, so in another embodiment of the present invention, in order to further ensure the accurate interconnection between optical waveguide paths, a positioning apparatus may be further disposed at a joint of the optical paths of the members.

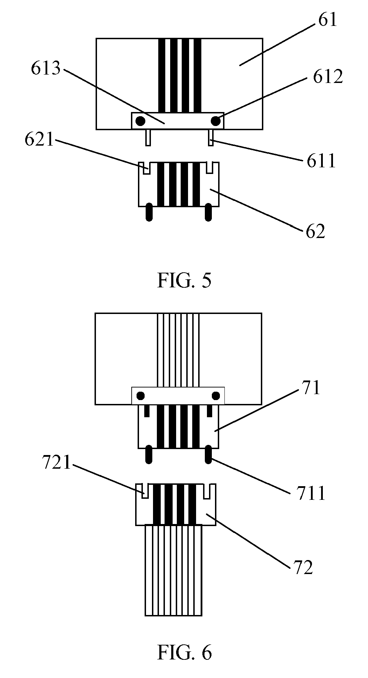

The front board and the first terminal of the connector may have a positioning apparatus configured to align the optical waveguide paths on the front board and the first terminal, for example, a first positioning apparatus is disposed on the front board, a second positioning apparatus is disposed on the first terminal, and the first positioning apparatus and the second positioning apparatus match with each, so as to align the optical waveguide paths located on the front board and the first terminal. The first positioning apparatus and the second positioning apparatus may adopt various manners, such as, setting a mark. In this embodiment, as shown in FIG. 5, the first positioning apparatus is specifically that, a positioning pin 611 is disposed on the front board 61 at a joint with the first terminal 62, the positioning pin may be fixed on the front board 61 with screws 612 and a fixing plate 613, and as shown in FIG. 5, fixing positions of the two screws 612 may be disposed on two sides of the optical waveguide path symmetrically, and specifically, positioning patterns of the fixing positions of the screws 612 may be marked on the front board 61. Correspondingly, as for the second positioning apparatus on the first terminal 62, a positioning hole 621 may be disposed at a position corresponding to the positioning pin 611, so that the positioning pin 611 may be inserted in the positioning hole 621, thereby ensuring the accurate interconnection of the optical waveguide paths of the front board 61 and the first terminal 62. Definitely, it should be understood that, in another embodiment, the second positioning apparatus may be a positioning pin, and the first positioning apparatus may be a positioning hole matching the positioning pin. The rear board and the second terminal also have positioning apparatuses configured to align the optical waveguide paths on the rear board and the second terminal, for example, a third positioning apparatus is disposed on the rear board, a fourth positioning apparatus is disposed on the second terminal, and the third positioning apparatus and the fourth positioning apparatus match each other, so as to align the optical waveguide paths located on the rear board and the second terminal. The third positioning apparatus and fourth positioning apparatus may adopt the setting similar to that of the first positioning apparatus and the second positioning apparatus, and may also adopt other positioning manners, which are not repeated herein.

The first terminal and the second terminal may also have positioning apparatuses configured to align the optical waveguide paths on the first terminal and the second terminal, for example, a fifth positioning apparatus is disposed on the first terminal, a sixth positioning apparatus is disposed on the second terminal, and the fifth positioning apparatus and the sixth positioning apparatus match each other, so as to align the optical waveguide paths located on the first terminal and the second terminal. In this embodiment, as shown in FIG. 6, the fifth positioning apparatus may be that, a positioning pin 711 is disposed on the first terminal 71 at a joint with the second terminal 72, and correspondingly, as for the sixth positioning apparatus on the second terminal 72, a positioning hole 721 is disposed on a position corresponding to the positioning pin 711, so that the positioning pin 711 may be inserted in the positioning hole 721, thereby ensuring the accurate interconnection of the optical waveguide paths on the first terminal 71 and the second terminal 72. Definitely, it is possible to dispose a positioning hole on the first terminal 71, and dispose a positioning pin on the second terminal 72, and the number of positioning holes (positioning pins) may be set according to requirements.

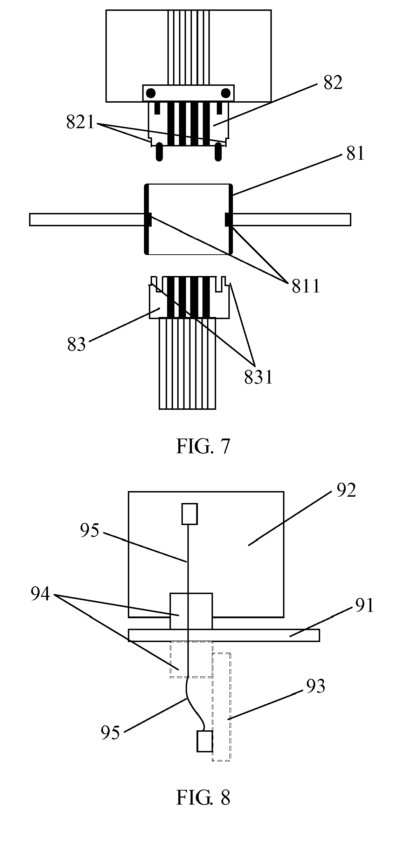

In this embodiment, the first terminal and the second terminal are mounted on the base of the backplane so as to implement the interconnection of the optical waveguide paths on the two terminals, in order to further accurately interconnect the first terminal and the second terminal, further, positioning apparatuses configured to align the optical waveguide paths on the first terminal and the second terminal are disposed on the base, the first terminal and the second terminal, for example, a seventh positioning apparatus is disposed on the base, an eighth positioning apparatus is disposed on the first terminal, a ninth positioning apparatus is disposed on the second terminal, and seventh positioning apparatus matches the eighth positioning apparatus and the ninth positioning apparatus, so as to align the optical waveguide paths located on the first terminal and the second terminal. As shown in FIG. 7, the seventh positioning apparatus may be a protrusion 811 disposed on an inner wall of the base 81 of the backplane, the eighth positioning apparatus is a recess 821 disposed at a position corresponding to the protrusion 811 on the first terminal 82, and the ninth positioning apparatus is a recess 831 disposed at a position corresponding to the protrusion 811 on the second terminal 83, so that when the first terminal 82 and the second terminal 83 are inserted in the base 81, the recess 821 and the recess 831 may match with the protrusion 811, thereby implementing the accurate interconnection of the optical waveguide paths on the first terminal 82 and the first terminal 83.

The optical waveguide paths on the front board and the rear board may also adopt flexible optical waveguide paths, in addition to the rigid optical waveguide paths embedded in the printed circuit boards.

It should be noted that, in an embodiment, as shown in FIG. 10, when multiple front boards (front boards 201-203 shown in the drawing) and one rear board 101 exist, the front boards 201-203 and the rear board 101 locate on two sides of the backplane 100 and are disposed to be orthogonal to each other, at this time, the one rear board 101 may be interconnected with the multiple front boards 201-203 respectively through multiple connectors (a connector 301, a connector 401 and a connector 501 in the drawing), and form an optical path with each front board after the interconnection, therefore, it is unnecessary to dispose an optical waveguide on the backplane, and direct communication with each front board implements the transmission of optical signals. As shown in FIG. 10, the connector 301, the connector 401 and the connector 501 may be mounted on the backplane 100 respectively through a base 300, a base 400 and a base 501 disposed on the backplane 100.

In an embodiment, when one front board or multiple rear boards exist, similar effect is obtained, which is not repeated herein.

In an embodiment, when multiple front boards and multiple rear boards exist, the front boards and the rear boards locate on two sides of the backplane and are disposed to be orthogonal to each other, at this time, each rear board may be interconnected with each front board through a connector disposed at a corresponding position on the backplane, so as to form an optical path with each front board after the interconnection; therefore, it is unnecessary to dispose an optical waveguide on the backplane, and each rear board and each front board are enabled to communicate with each other directly to implement the transmission of optical signals.

In the embodiments of the present invention, the front board and the rear board of a circuit board locate on two sides of the backplane and are disposed to be orthogonal to each other, and the optical waveguide paths in the front board and the rear board are interconnected through the first terminal and the second terminal of the connector to form the optical path, thereby implementing the transmission of optical signals without establishing an optical waveguide path on the backplane, shortening an optical link, and reducing the loss of the optical signals. By using the optical waveguide path, the embodiments of the present invention improve the processing performance of the system, and reduce the complexity of physical implementation of a high-density fiber backplane. Moreover, the backplane of the system does not have an optical waveguide path, which also reduces the difficulty of physical implementation of the system. Further, by disposing positioning apparatuses on the front board and the rear board, the interconnection of the optical waveguide paths between the front board and the rear board become more accurate.

Referring to FIG. 8, a schematic structural diagram of another optical backplane interconnection system in an embodiment of the present invention is shown.

In this embodiment, the optical backplane interconnection system may include a backplane 91, a front board 92, and a rear board 93, where the front board and the rear board all adopt flexible waveguide plates, and the front board and the rear board may be assembled through a connector to implement the interconnection of optical waveguide paths. In this embodiment, the front board and the rear board implementing the interconnection of the optical waveguide paths through a connector 94 is taken as an example for illustration.

In this embodiment, flexible optical waveguide paths 95 are adopted to avoid additional loss caused by turning an optical path for 90 degrees by a reflector when adopting a rigid waveguide. The assembling and positioning relationships between the flexible optical waveguide paths 95 on the front board and the rear board and the first terminal and the second terminal of the connector are similar to those in the foregoing embodiment, except that the flexible optical waveguide paths are not embedded in the printed circuit boards, and therefore, during assembling, the flexible optical waveguide paths 95 and the connector 94 are assembled together first and then assembled with the rigid front board and rear board.

In this embodiment, the transmission procedure of an optical signal in the optical backplane interconnection system is that, an optical signal of the transmitting chip (TX) enters the optical waveguide path of the front board 92 through the connector, and is transmitted to the rear board 93 on the rear side of the backplane 91 through the connector 94, and the optical signal enters the receiving chip (RX) through the waveguide connector, thereby implementing the transmission of the signal.

It should be noted that, in an embodiment, as shown in FIG. 10, when multiple front boards (front boards 201-203 shown in the drawing) and one rear board 101 exist, the front boards 201-203 and the rear board 101 locate on two sides of the backplane 100 and are disposed to be orthogonal to each other, at this time, the one rear board 101 may be interconnected with the multiple front boards 201-203 respectively through multiple connectors (a connector 301, a connector 401 and a connector 501 in the drawing), and form an optical path with each front board after the interconnection, therefore, it is unnecessary to dispose an optical waveguide on the backplane, and direct communication with each front board implements the transmission of optical signals. As shown in FIG. 10, the connector 301, the connector 401 and the connector 501 may be mounted on the backplane 100 respectively through a base 300, a base 400 and a base 501 disposed on the backplane 100.

In an embodiment, when one front board or multiple rear boards exist, similar effect is obtained, which is not repeated herein.

In an embodiment, when multiple front boards and multiple rear boards exist, the front boards and the rear boards locate on two sides of the backplane and are disposed to be orthogonal to each other, at this time, each rear board may be interconnected with each front board through a connector disposed at a corresponding position on the backplane, so as to form an optical path with each front board after the interconnection; therefore, it is unnecessary to dispose an optical waveguide on the backplane, and each rear board and each front board are enabled to communicate with each other directly to implement the transmission of optical signals.

In this embodiment, the front board and the rear board in the circuit board are respectively located at each side of the backplane and are disposed to be orthogonal to each other, the optical waveguide paths in the front board and the rear board are interconnected through the connector to form the optical path, so as to implement the transmission of optical signals without establishing an optical waveguide path on the backplane, thereby shortening the optical link, and reducing the loss of the optical signals. Moreover, by adopting flexible optical waveguide paths, additional loss caused by turning an optical path for 90 degrees by a reflector when adopting a rigid waveguide is avoided. The backplane in this embodiment does not have any optical waveguide path, which also reduces the difficulty in physical implementation of the system.

In the foregoing embodiment, the specific configuration of the connector 94 may also be similar to the previous embodiments, and is not repeated herein.

Referring to FIG. 9, a schematic structural diagram of a communication device in an embodiment of the present invention is shown.

The communication device may include a switch board 91 and an optical backplane interconnection system 92 connected to the switch board 91.

The optical backplane interconnection system 92 includes a backplane, a front board, a rear board and a connector. The front board and the rear board locate on two sides of the backplane and are orthogonal to each other. The front board and the rear board are both disposed with an optical waveguide path which is interconnected through a connector connected to the backplane to form an optical path, so that optical signals can be transmitted through the optical path. The specific structure of the optical backplane interconnection system 92 may be similar to the foregoing embodiment, and is not repeated herein. The switch board 91 is provided with a driver or acceptor of waveguide interface, so as to be connected to the optical backplane interconnection system 92.

The communication device is widely applied in network devices, such as a router, a transmission device, and a server. In other embodiments, the communication device may further include a service board, where the service board has an optical module, and the service board also has a driver or an acceptor of waveguide interface.

In the optical backplane interconnection system 92 in the communication device, the front board and the rear board of a circuit board locate on two sides of the backplane and are disposed to be orthogonal to each other, and the optical waveguide paths in the front board and the rear board are interconnected directly through the connector to form the optical path, thereby implementing the transmission of optical signals without establishing an optical waveguide path on the backplane, shortening an optical link, and reducing the loss of the optical signals. By using the optical waveguide path, the embodiments of the present invention improve the processing performance of the system, and reduce the complexity of physical implementation of a high-density fiber backplane. Moreover, the backplane of the system does not have an optical waveguide path, which also reduces the difficulty of physical implementation of the system.

Embodiments of the present invention described in the foregoing are not limitations for the protection scope of the present invention. Any modification, equivalent replacement, and improvement made without departing from the spirit and principle of the present invention all fall in the protection scope of the embodiments of the present invention.

## Claims

1. An optical backplane interconnection system, comprising a backplane, a front board, a rear board and a connector, wherein the front board and the rear board locate on two sides of the backplane and are orthogonal to each other, the front board and the rear board are both disposed with an optical waveguide path which is interconnected through a connector connected to the backplane to form an optical path, so that optical signals are transmitted through the optical path.

2. The optical backplane interconnection system according to claim 1, wherein,
the connector comprises a first terminal connected to the front board and a second terminal connected to the rear board, the first terminal and the second terminal both have an optical waveguide path;
the optical waveguide paths on the front board and the rear board being interconnected through the connector connected to the backplane to form the optical path is specifically:
the optical waveguide paths on the front board, the first terminal of the connector, the second terminal of the connector and the rear board are interconnected sequentially to form the optical path.

3. The optical backplane interconnection system according to claim 2, wherein, a first positioning apparatus is disposed on the front board, a second positioning apparatus is disposed on the first terminal, and the first positioning apparatus and the second positioning apparatus match each other, so as to align the optical waveguide paths located on the front board and the first terminal.

4. The optical backplane interconnection system according to claim 3, wherein, the first positioning apparatus and the second positioning apparatus are located at a joint of the front board and the first terminal, the first positioning apparatus comprises a positioning pin disposed on the front board, and the second positioning apparatus comprises a positioning hole disposed on the first terminal and corresponding to the positioning pin.

5. The optical backplane interconnection system according to claim 2, wherein, a third positioning apparatus is disposed on the rear board, a fourth positioning apparatus is disposed on the second terminal, and the third positioning apparatus and the fourth positioning apparatus match each other, so as to align the optical waveguide paths located on the rear board and the second terminal.

6. The optical backplane interconnection system according to claim 5, wherein, the third positioning apparatus and the fourth positioning apparatus are located at a joint of the rear board and the second terminal, the third positioning apparatus comprises a positioning pin disposed on the rear board, and the fourth positioning apparatus comprises a positioning hole disposed on the second terminal and corresponding to the positioning pin.

7. The optical backplane interconnection system according to claim 2, wherein, a fifth positioning apparatus is disposed on the first terminal, a sixth positioning apparatus is disposed on the second terminal, and the fifth positioning apparatus and the sixth positioning apparatus match each other, so as to align the optical waveguide paths located on the first terminal and the second terminal.

8. The optical backplane interconnection system according to claim 7, wherein, the fifth positioning apparatus and the sixth positioning apparatus are located at a joint of the first terminal and the second terminal, the fifth positioning apparatus comprises a positioning pin disposed on the first terminal, and the sixth positioning apparatus comprises a positioning hole disposed on the second terminal and corresponding to the positioning pin.

9. The optical backplane interconnection system according to claim 2, wherein, the backplane has a base configured to mount the first terminal and second terminal.

10. The optical backplane interconnection system according to claim 9, wherein, a seventh positioning apparatus is disposed on the base, an eighth positioning apparatus is disposed on the first terminal, a ninth positioning apparatus is disposed on the second terminal, and the seventh positioning apparatus matches the eighth positioning apparatus and the ninth positioning apparatus, so as to align the optical waveguide paths located on the first terminal and the second terminal.

11. The optical backplane interconnection system according to claim 10, wherein, the seventh positioning apparatus comprises a protrusion disposed on the backplane base, the eighth positioning apparatus comprises a recess disposed on the first terminal at a position corresponding to the protrusion, and the ninth positioning apparatus comprises a recess disposed on the second terminal at a position corresponding to the protrusion.

12. The optical backplane interconnection system according to any one of claims 1 to 11, wherein,
the optical waveguide paths are rigid optical waveguide paths embedded in the front board and the rear board; or flexible optical waveguide paths assembled on the front board and the rear board.

13. A communication device, comprising the optical backplane interconnection system according to any one of claims 1 to 11, and a switch board connected to the optical backplane interconnection system.

14. The communication device according to claim 13, wherein, optical waveguide paths are rigid optical waveguide paths embedded in a front board and a rear board; or flexible optical waveguide paths assembled on the front board and the rear board.
